# FASCICULE DE BREVET EUROPEEN

(11) **EP 0 517 623 B1**
(45) Date de publication et mention de la délivrance du brevet: **06.05.1998**
(21) Numéro de dépôt: 92420176.7
(22) Date de dépôt: 26.05.1992
(51) Int. Cl.: H01L 29/10, H01L 27/08

(54) **Transistor de gain en courant prédéterminé dans un circuit intégré bipolaire**
Transistor mit einer vorbestimmten Stromverstärkung in einer integrierten Bipolarschaltung
Transistor with a predetermined current gain in a bipolar integrated circuit

(30) Priorité: 31.05.1991 FR 9106896
(43) Date de publication de la demande: 09.12.1992
(73) Titulaire: SGS-THOMSON MICROELECTRONICS S.A., 94250 Gentilly (FR)
(72) Inventeur: Moreau, Jean-Michel, F-38100 Grenoble (FR)
(74) Mandataire: de Beaumont, Michel

(56) Documents cités:
- FR-A- 2 101 228
- FR-A- 2 282 721
- US-A- 3 810 123
- PATENT ABSTRACTS OF JAPAN vol. 6, no. 194 (E-134)(1072) 2 Octobre 1982 & JP-A-57 106 160
- IBM TECHNICAL DISCLOSURE BULLETIN, vol. 27, no. 1A, Juin 1984, New York, US, pp. 234-236; R.C. WONG : 'Integrated NPN transistors with different current gains'

## Description

La présente invention concerne le domaine des circuits intégrés bipolaires et plus particulièrement la formation dans un circuit intégré bipolaire de transistors présentant des gains relatifs prédéterminés.

La présente invention sera plus particulièrement exposée dans le cas de circuits intégrés bipolaires à isolement par jonction.

Dans un circuit intégré, on utilise de très nombreux composants identiques assemblés de diverses façons en divers circuits. Tous les composants sont fabriqués à l'identique pour que les caractéristiques des circuits obtenus à partir de ces composants soient déterminables. En effet, dans un circuit intégré classique, si, par exemple, on utilise deux types distincts de transistors NPN, tous les transistors d'un type donné auront des caractéristiques déterminées mais les relations entre les caractéristiques de transistors du premier type et de transistors du deuxième type seront généralement sujettes à variation en fonction des variations de la technologie de fabrication (notamment variation des niveaux de dopage des diverses couches et des profondeurs de diffusion liées aux recuits).

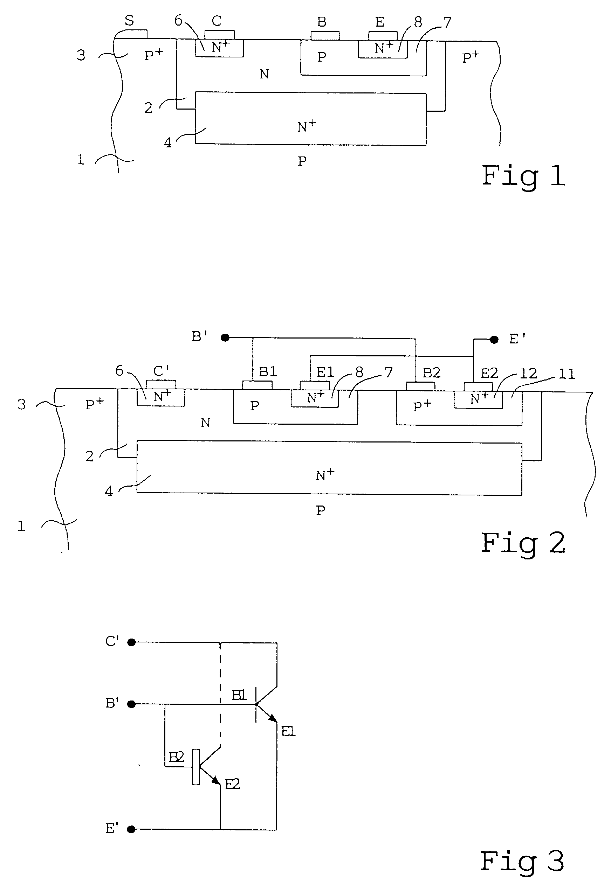

La figure 1 représente le composant de base d'un circuit intégré bipolaire classique à isolement par jonction dans le cas où le substrat est de type P et où les divers éléments sont formés dans des caissons de type N.

Le circuit intégré est formé à partir d'un substrat 1 en semiconducteur monocristallin d'un premier type de conductivité, par exemple du silicium de type P. Au-dessus de ce substrat est formée une couche du type de conductivité opposé, N, généralement par épitaxie. C'est cette couche N qui est divisée en caissons 2 par des diffusions profondes du premier type de conductivité 3 rejoignant le substrat 1 à partir de la surface de la plaquette. Couramment, le fond du caisson comprend une région enterrée 4 du deuxième type de conductivité à fort niveau de dopage. Un transistor NPN formé dans le caisson 2 comprend une région de collecteur qui correspond au caisson 2. Un contact de collecteur C est pris sur cette région 2 par l'intermédiaire d'une zone surdopée 6. A partir de la surface du caisson, est formée par implantation/diffusion une région en cuvette 7 de type P qui correspondra à la base du transistor NPN. A l'intérieur de la région de base, est formée une région N⁺ d'émetteur 8. Un contact de base B est formé sur la région 7. Une métallisation d'émetteur E est formée sur la région d'émetteur 8.

Les niveaux de dopage, les profondeurs de jonction et les gradients de concentration au niveau des jonctions émetteur-base et base-collecteur déterminent les caractéristiques du transistor NPN obtenu et notamment son gain en courant et sa tension de claquage BV_{CEO}. Normalement, pour fabriquer des transistors NPN présentant des gains en courant différents de ceux représentés en figure 1, il faudra modifier l'une de leurs caractéristiques, par exemple le dopage de leur base ou de leur émetteur, mais alors ces deuxièmes transistors n'auront pas, dans des lots de fabrication différents, des gains déterminés avec précision par rapport aux premiers transistors.

De tels transistors NPN modifiés par rapport aux premiers ont déjà été réalisés dans l'art antérieur, par exemple comme cela est décrit dans JP-A-57 106 160 (Hitachi), FR-A-2 101 228 (IBM) ou FR-A-2 282 721 (RCA). Dans le brevet IBM, un transistor normal et un transistor à très faible gain en courant sont rassemblés dans un même caisson et le transistor à très faible gain est destiné à fonctionner en diode, cette diode étant éventuellement reliée par son anode à la base du transistor normal. Aucun de ces documents ne décrit un nouveau transistor à gain déterminé constitué de deux transistors élémentaires interconnectés.

Un objet de la présente invention est de prévoir, dans un circuit intégré bipolaire comprenant des premiers transistors bipolaires "normaux", des deuxièmes transistors bipolaires présentant par rapport aux premiers un rapport de gain déterminé indépendamment des variations des paramètres de fabrication et de la température.

Pour atteindre cet objet, la présente invention prévoit de former dans un même caisson un premier transistor bipolaire élémentaire "normal" et un deuxième transistor bipolaire élémentaire à base très fortement dopée, les bases et les émetteurs de ces deux transistors étant interconnectés. Pour obtenir un transistor bipolaire présentant, par rapport aux transistors bipolaires normaux du circuit, un gain en courant de 1/k+1, on prévoit que, dans un caisson donné, le transistor élémentaire à base très fortement dopée présente une surface d'émetteur k fois plus élevée que celle du transistor élémentaire normal.

Plus particulièrement, la présente invention prévoit un circuit intégré bipolaire à caissons d'un premier type de conductivité formés dans un substrat du deuxième type de conductivité, comprenant dans des premiers caissons des premiers transistors dont le caisson constitue le collecteur à l'intérieur duquel est formée une région de base du deuxième type de conductivité contenant elle-même une région d'émetteur du premier type de conductivité. Ce circuit intégré comprend, dans au moins un deuxième caisson formant collecteur, un deuxième transistor constitué d'un troisième transistor élémentaire comprenant des régions de même dopage que les premiers transistors et d'un quatrième transistor élémentaire ayant une région de base à niveau de dopage élevé devant celui des bases des premiers transistors et une région d'émetteur de même niveau de dopage que celui des premiers transistors, les émetteurs et les bases des troisième et quatrième transistors étant interconnectés et constituant respectivement l'émetteur et la base du second transistor.

Ainsi, la présente invention prévoit un circuit intégré bipolaire comprenant dans des caissons isolés formant collecteur des premiers transistors et un deuxième transistor présentant par rapport aux premiers un gain en courant dans un rapport 1/k+1, ce deuxième transistor étant constitué par la connexion en parallèle d'un troisième et d'un quatrième transistor élémentaire formés dans un même caisson de collecteur, le troisième transistor étant identique aux premiers et le quatrième transistor ayant une base très fortement dopée par rapport aux premiers et un émetteur de même dopage, la surface d'émetteur du quatrième transistor étant k fois plus grande que celle du troisième.

Selon un mode de réalisation de l'invention, les caissons sont isolés par jonction et le fond de chaque caisson comprend une couche enterrée du premier type de conductivité à haut niveau de dopage.

Selon un mode de réalisation de l'invention, les bases des quatrièmes transistors sont environ mille fois plus dopées par unité de surface que les bases des premiers transistors.

Selon un mode de réalisation de l'invention, les bases des troisième et quatrième transistors sont adjacentes.

Ces objets, caractéristiques et avantages ainsi que d'autres de la présente invention seront exposés en détail dans la description suivante de modes de réalisation particuliers faite en relation avec les dessins joints parmi lesquels :
la figure 1 représente la structure classique d'un transistor NPN dans un circuit intégré bipolaire à caissons isolés par jonction ;
la figure 2 représente un premier mode de réalisation de la présente invention ;
la figure 3 représente le schéma équivalent d'un transistor à gain réglable selon la présente invention ;
la figure 4 représente un deuxième mode de réalisation de la présente invention ; et
la figure 5 représente en vue de dessus un mode de réalisation de la présente invention.

Dans les figures 1, 2, 4 et 5, les diverses couches ne sont pas représentées à l'échelle, leurs dimensions étant arbitrairement agrandies ou rétrécies pour améliorer la lisibilité des figures, comme cela est classique dans le domaine de la représentation des composants semiconducteurs. De plus, les formes des couches ne correspondent pas aux formes réelles. Notamment, les divers bords et coins de couches représentés comme rectangulaires sont en fait arrondis par suite des diverses étapes de diffusion et de recuit. En outre, dans ces figures, les régions ou zones identiques ou équivalentes sont désignées par les mêmes références numériques.

La figure 2 représente un transistor NPN, E'B'C', à gain prédéterminé selon la présente invention. Une structure E₁B₁C' équivalente à la stucture EBC de la figure 1, constitue un premier transistor élémentaire. En outre, dans le même caisson, sont prévues une deuxième région de base 11 et une deuxième région d'émetteur 12 pour former un deuxième transistor élémentaire d'émetteur E₂, de base B₂ et de collecteur C'.

Les niveaux de dopage des couches de base et d'émetteur 7 et 8 du transistor élémentaire E₁B₁C' sont strictement identiques à celles du transistor de la figure 1. Par contre, la région de base 11 est fortement dopée par rapport à la région de base 7. La région d'émetteur 12 présente le même niveau de dopage que la région d'émetteur 8. Les bases B₁ et B₂ sont interconnectées, ou bien de façon externe ou bien par des métallisations sur le composant, pour former la base B' du transistor à gain prédéterminé et les régions d'émetteur E₁ et E₂ sont interconnectées pour former l'émetteur E' du transistor à gain prédéterminé.

Le rapport k entre la surface de la région d'émetteur 8 et la surface de la région d'émetteur 12 est déterminé de la façon exposée ci-après pour fixer le gain du transistor.

On va d'abord rappeler les mécanismes qui fixent le gain en courant d'un transistor.

Quand une tension V_{BE} est appliquée entre base et émetteur d'un transistor, il se crée deux flux de porteurs.
- L'émetteur injecte dans la base un flux de porteurs inversement proportionnel au nombre de Gummel de cette base (le nombre de Gummel est le nombre d'atomes dopants introduits par unité de surface dans chaque région du transistor). Dans un transistor présentant des valeurs de dopage classiques tel que celui de la figure 1, pratiquement tous ces porteurs traversent la base et constituent le courant de collecteur.
- La base injecte dans l'émetteur un flux de porteurs inversement proportionnel au nombre de Gummel de l'émetteur. Ces porteurs constituent la quasi-totalité du courant de base.

Le gain en courant d'un transistor, égal au rapport entre le courant de collecteur et le courant de base est donc égal au rapport des nombres de Gummel de l'émetteur et de la base (il sera élevé si ce rapport est élevé). En fait, il s'agit là d'une explication simplifiée et des facteurs correcteurs doivent être appliqués, notamment pour tenir compte des forts dopages d'émetteur. En conséquence il faut noter que le gain n'est pas égal mais directement lié au rapport des nombres de Gummel. Cette remarque n'affecte pas les explications ci-après où l'on considère des transistors de même dopage d'émetteur.

Si l'on compare le transistor élémentaire B₂E₂C' au transistor élémentaire B₁E₁C', pour une même tension base-émetteur, et de mêmes surfaces d'émetteurs, le courant de base sera le même car le nombre de Gummel des émetteurs est le même. Toutefois, pour le transistor élémentaire B₂E₂C', le courant collecteur sera très faible, par exemple nettement inférieur au courant de base car le nombre de Gummel de la seconde base est très grand. Le deuxième transistor présente donc un gain en courant très faible.

Si l'on considère le transistor E'B'C' constitué de l'association en parallèle des transistors E₁B₁C' et E₂B₂C', et que l'on injecte un courant I_{B} dans la borne de base B', ce courant se répartira également entre les deux transistors puisque les émetteurs de ces deux transistors ont le même nombre de Gummel. Ainsi il circulera un courant de base moitié dans le transistor E₁B₁C' qui donc présentera un courant collecteur moitié de celui qu'il aurait en l'absence du transistor E₂B₂C'. Comme le courant de collecteur du transistor E₂B₂C' est pratiquement nul, le gain en courant du transistor E'B'C' de la figure 2 est donc divisé par 2 par rapport à celui du transistor EBC de la figure 1. Plus généralement, si le rapport entre les surfaces des régions d'émetteur 8 et 12 est égal à k, le gain du transistor E'B'C' sera égal à 1/k+1 fois le gain du transistor EBC de la figure 1.

On a ainsi réalisé un nouveau transistor présentant un gain déterminé par rapport à celui des transistors "normaux", le nouveau gain étant fixé par le rapport entre les surfaces d'émetteur, paramètre qui est réglable de façon simple et fiable en circuit intégré puisqu'il dépend seulement de la surface de masques et non de paramètres technologiques. En outre, puisque les deux transistors élémentaires E₂B₂C' et E₁B₁C' sont réalisés dans un même caisson, ces deux transistors verront leurs paramètres varier de la même façon en fonction des variations de température et le rapport entre le gain du transistor selon l'invention et le gain du transistor classique restera constant avec les variations de température.

Ainsi, la présente invention propose un nouveau type de composant bipolaire constituant un transistor de gain déterminé et ajustable par rapport aux autres transistors du circuit. On pourra si on le souhaite multiplier dans un même circuit intégré bipolaire des transistors de gains distincts ce qui permet à l'homme de l'art de créer de nouveaux types de circuits de façon simple.

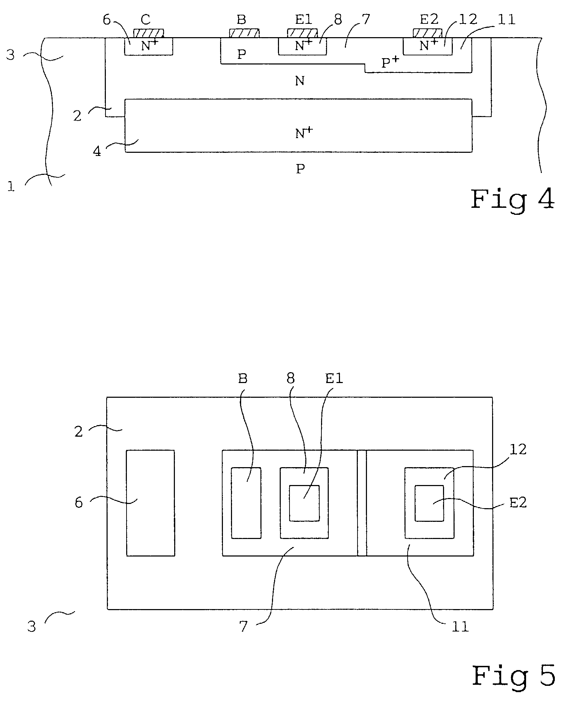

Les figures 4 et 5 représentent en coupe et en vue de dessus une variante de la présente invention. Les régions de base 7 et 11, au lieu d'être disjointes, sont adjacentes.

A titre d'exemple de niveaux de dopage, on pourra prévoir, pour les diverses régions d'un transistor selon l'invention les niveaux de dopage ou valeurs de résistance (r) en ohms par carré et profondeur de jonction (x) en micromètres, les valeurs suivantes :

| | |
|---|---|
| collecteur 2 de type N | 2.10¹⁵ at./cm³ |
| base 7 de type P (hors zone d'émetteur) | r = 130, x = 3 |
| base 11 de type P⁺ (hors zone d'émetteur) | r = 10 , x = 6 à 15 |
| émetteur 8 et 12 de type N⁺ | r = 5 , x = 2,8 |

Avec des valeurs de cet ordre, le transistor E₁B₁C' a un gain de l'ordre de 50 à 500 et le transistor E₂B₂C' un gain inférieur à 0,1.

Le rapport entre les quantités de dopant dans les bases 11 et 8 pourra atteindre des valeurs de l'ordre de 1000.

Bien entendu, la présente invention est susceptible de nombreuses variantes qui apparaîtront à l'homme de l'art. Notamment, tous les perfectionnements habituellement appliqués aux structures de transistors NPN pourront être utilisés. Par exemple, alors que seules des structures classiques de caissons bipolaires à isolement par jonction ont été représentées ici, l'invention s'appliquerait également à des caissons isolés par diélectrique. De plus, chacun des éléments a été décrit et représenté de façon simplifiée. Ainsi, il existera généralement des couches superficielles d'isolement non représentées et éventuellement des régions surdopées de reprise de contact...

## Revendications

1. Circuit intégré bipolaire à caissons (2) d'un premier type de conductivité formés dans un substrat (1) du deuxième type de conductivité, comprenant dans des premiers caissons des premiers transistors (EBC) dont le caisson constitue le collecteur à l'intérieur duquel est formée une région de base (7) du deuxième type de conductivité contenant elle-même une région d'émetteur (8) du premier type de conductivité, caractérisé en ce qu'il comprend, dans au moins un deuxième caisson formant collecteur, un deuxième transistor (E'B'C') constitué d'un troisième transistor élémentaire (E₁B₁C') comprenant des régions de même dopage que les premiers transistors et d'un quatrième transistor élémentaire (E₂B₂C') ayant une région de base (11) à niveau de dopage élevé devant celui des bases des premiers transistors et une région d'émetteur (12) de même niveau de dopage que celui des premiers transistors, les émetteurs et les bases des troisième et quatrième transistors étant interconnectés et constituant respectivement l'émetteur et la base du second transistor.

2. Circuit intégré bipolaire selon la revendication 1, caractérisé en ce que la surface d'émetteur du quatrième transistor est k fois plus grande que celle du troisième, d'où il résulte que le deuxième transistor (E'B'C') présente par rapport aux premiers un gain en courant dans un rapport de 1/k+1.

3. Circuit intégré bipolaire selon l'une des revendications 1 et 2, dans lequel les caissons sont isolés par jonction et le fond de chaque caisson comprend une couche enterrée du premier type de conductivité à haut niveau de dopage.

4. Circuit intégré bipolaire selon l'une quelconque des revendications 1 à 3, caractérisé en ce que les bases des quatrièmes transistors sont mille fois plus dopées par unité de surface que les bases des premiers transistors.

5. Circuit intégré bipolaire selon l'une quelconque des revendications 1 à 4, caractérisé en ce que les bases des troisième et quatrième transistors sont adjacentes.

## Patentansprüche

1. Integrierte Bipolarschaltung mit in einem Substrat (1) eines zweiten Leitfähigkeitstyps ausgebildeten Gräben (2) eines ersten Leitfähigkeitstyps, wobei die Schaltung in ersten Gräben erste Transistoren (EBC) umfaßt, deren Graben den Kollektor bildet, in dessen Innerem ein Basisbereich (7) vom zweiten Leitfähigkeitstyp ausgebildet ist, der seinerseits einen Emitterbereich (8) vom ersten Leitfähigkeitstyp enthält,
dadurch gekennzeichnet, daß die Schaltung in wenigstens einem einen Kollektor bildenden zweiten Graben einen zweiten Transistor (E'B'C') umfaßt, der durch einen dritten Elementartransistor (E₁B₁C') mit Bereichen gleicher Dotierung wie die ersten Transistoren und durch einen vierten Elementartransistor (E₂B₂C') gebildet wird, der einen Basisbereich (11) von höherem Dotierungspegel als dem der Basen der ersten Transistoren und einen Emitterbereich (12) von gleichem Dotierungspegel wie dem der ersten Transistoren aufweist, wobei die Emitter und die Basen des dritten und des vierten Transistors miteinander verbunden sind und den Emitter bzw. die Basis des zweiten Transistors darstellen.

2. Integrierte Bipolarschaltung nach Anspruch 1,
dadurch gekennzeichnet, daß die Emitteroberfläche des vierten Transistors k mal größer als die des dritten Transistors ist, derart, daß der zweite Transistor (E'B'C') relativ bezüglich den ersten Transistoren eine Stromverstärkung im Verhältnis von 1/k+1 aufweist.

3. Integrierte Bipolarschaltung nach einem der Ansprüche 1 und 2, bei welcher die Gräben durch PN-Übergänge isoliert sind und der Boden jedes Grabens eine vergrabene Schicht vom ersten Leitfähigkeitstyp mit hohem Dotierungspegel aufweist.

4. Integrierte Bipolarschaltung nach einem der Ansprüche 1 bis 3,
dadurch gekennzeichnet, daß die Basen der vierten Transistoren je Oberflächeneinheit tausendfach stärker dotiert sind als die Basen der ersten Transistoren.

5. Integrierte Bipolarschaltung nach einem der Ansprüche 1 bis 4,
dadurch gekennzeichnet, daß die Basen der dritten und vierten Transistoren benachbart sind.

## Claims

1. A bipolar integrated circuit with wells (2) of a first conductivity type, formed in a substrate (1) of the second conductivity type, comprising, in first wells, first transistors (EBC), the well of which constitutes the collector inside which is formed a base region (7) of the second conductivity type containing in turn an emitter region (8) of the first conductivity type, characterized in that it comprises, in at least a second well forming a collector, a second transistor (E'B'C') constituted by a third elementary transistor (E₁B₁C') comprising regions of the same doping level as the first transistors and a fourth elementary transistor (E₂B₂C') having a base region (11) with a high doping level with respect to that of the bases of the first transistors and an emitter region (12) having the same doping level as that of said first transistors, the emitters and bases of the third and fourth elementary transistors being interconnected and constituting the emitter and the base of the second transistor, respectively.

2. A bipolar integrated circuit according to claim 1, characterized in that, the emitter surface of said fourth transistor is k times larger than that of said third transistor, whereby the second transistor (E'B'C) has a current gain that is 1/K+1 times the current gain of the first transistors.

3. A bipolar integrated circuit according to claim 1 or 2, wherein said wells are isolated by junction and the bottom of each said well comprises a buried layer of the first conductivity type having a high doping level.

4. A bipolar integrated circuit according to any of claims 1 to 3, wherein the bases of said fourth transistors are a thousand times more doped per surface unit than the bases of said first transistors.

5. A bipolar integrated circuit according to any of claims 1 to 4, wherein the bases of the third and fourth transistors are adjacent.
